# EUROPEAN PATENT APPLICATION

(11) **EP 0 524 763 A2**
(43) Date of publication of application: **27.01.1993**
(21) Application number: 92306480.2
(22) Date of filing: 15.07.1992
(51) Int. Cl.: H01L 23/66

(54) **RF device package**

(30) Priority: 22.07.1991 US 733903
(71) Applicant: MOTOROLA, INC., Schaumburg, IL 60196 (US)
(72) Inventor: Pollock, Randy L., Phoenix, Arizona 85028 (US)
(74) Representative: Dunlop, Hugh Christopher

(57) **Abstract**

An RF device package (10,30) in accordance with the present invention includes a heatsink (12,44) having an RF die (14,36) die bonded directly thereto. An electrically insulating polymer film (18,40) is disposed on the heatsink (12,44) about the RF die (14,36). The polymer film (18,40) includes input and output leads (20,22,32,34) thereon that are electrically coupled to the RF die (14,36). The capacitance is controlled by varying the thickness of the polymer film (18,40) or by varying the surface area of the leads (20,22,32,34) disposed on the polymer film (18,40).

## Description

### Field of the Invention

This invention relates, in generally, to semiconductor devices and more particularly to an RF device package.

### Background of the Invention

RF devices are well known and commonly used in relatively high frequency applications such as in radios and cellular telephones. RF devices differ from the majority of other semiconductor devices in that they cannot merely be disposed on a circuit board without being frequency matched. Matching requires the addition or subtraction of inductance and capacitance into a circuit to control feedback to the RF device. If feedback is not controlled in an RF device, the entire circuit will be basically inoperable.

Many prior art RF device packages are extremely expensive and difficult to fabricate. One particular prior art RF device package includes a metal heatsink having a pedestal on which a ceramic insulator is mounted. The pedestal is required to prohibit cracking of the ceramic insulator during fabrication and use. The ceramic insulator includes metal lines patterned thereon. An RF device is die bonded directly to the ceramic insulator and is then wirebonded to metal leads disposed on each side of the ceramic insulator. Following wirebonding, a ceramic cap is formed over the RF device.

In addition to being expensive and difficult to fabricate, the use of the ceramic insulator may be hazardous. Perhaps the most common ceramic insulator employed is berrilyium oxide (BeO) which is toxic in powdered form. In addition to the health hazards, the toxicity of berrilyim oxide powder has resulted in increased government regulation dealing with its use. RF device packages that employ ceramics such as berrilyium oxide are also relatively difficult to match.

Accordingly, it would be highly desirable to have an RF device package which is relatively inexpensive to fabricate, poses minimal toxicity hazards and may be easily matched.

### Summary of the Invention

An RF device package includes a heatsink having an RF die bonded directly thereto. An electrically isolating polymer film is disposed on the heatsink about the RF die. Input and output leads are disposed on the electrically isolating film and are electrically coupled to the RF die.

### Brief Description of the Drawings

FIG. 1 is a highly enlarged isometric view of an embodiment of an RF device package in accordance with the present invention; and
FIG. 2 is a highly enlarged isometric view of another embodiment of an RF device package in accordance with the present invention.

### Detailed Description of the Drawings

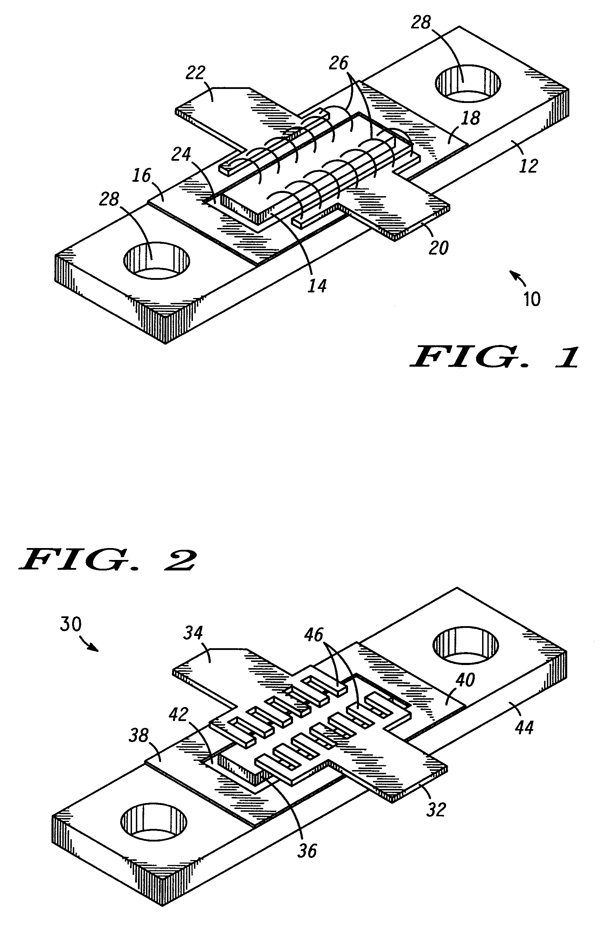

FIG. 1 is a highly enlarged isometric view of an RF device package 10 in accordance with the present invention. Package 10 includes a heatsink 12 which may comprise one of many well known metals or metal alloys. Heatsink 12 is fabricated from powdered metallurgy and should have a thermal expansion coefficient similar to any die mounted thereon. In this embodiment, heatsink 12 comprises a copper tungsten alloy or a silicon carbide aluminum alloy. These materials have thermal expansion coefficients similar to silicon. A silicon RF die 14 is die bonded directly to heatsink 12. A gold silicon eutectic die bond is preferred although other die bond or die attach methods may be utilized. The die bond material should be electrically as well as thermally conductive.

A lead tape 16 comprising a polymer film 18 and metal leads 20 and 22 is disposed on heatsink 12. Polymer film 18 may comprise one of many well known polymers such as a polyimide and must be electrically insulating. Kapton film manufactured by the DuPont company is excellent for this application. Leads 20 and 22 comprise a copper foil or a similar metal. Lead tape 16 is fabricated by depositing a metal layer on polymer film 18 and then etching the metal layer to provide leads 20 and 22 as desired. Although only two leads 20 and 22 are depicted herein, the present invention may be employed with various numbers of leads. Lead tape 16 will commonly be supplied in a roll having many other lead tapes attached thereto. Lead tape 16 includes a window 24 disposed between leads 20 and 22. Lead tape 16 is disposed on heatsink 12 so that window 24 is disposed about die 14 which has been previously die bonded directly to heatsink 12. Although lead tapes 16 having various polymer films will immediately adhere to heatsink 12, many polymer films 18 such as Kapton film will require a cure step to adequately adhere to heatsink 12.

Once lead tape 16 has been disposed on heatsink 12 about die 14, die 14 is wirebonded to leads 20 and 22 via wire bonds 26. Wirebonding may be performed by methods well known in the art.

Following wirebonding, the portion of package 10 including die 14 and wire bonds 26 will be either encapsulated or capped to protect die 14 and wire bonds 26 from the environment. As shown, heat sink 12 is electrically coupled to a source through the backside of die 14 and serves as a ground. Lead 20 is electrically coupled to a base of die 14 and serves as an input lead. Lead 22 is electrically coupled to a drain of die 14 and serves as an output lead.

When package 10 is completed, it may be physically attached to a printed circuit board or the like via screw holes 28. Unlike many other integrated circuits, an RF integrated circuit may not be merely connected into the printed circuit board and properly function. An RF device must be frequency matched to control feedback to die 14 so that it will function properly. Matching is performed by adding or subtracting inductance and capacitance to an RF circuit.

Package 10 in accordance with the present invention includes features which allow matching to be performed relatively easily. Capacitance may be controlled by varying the thickness of polymer film 18 of lead tape 16. As the thickness of polymer film 18 is increased, the capacitance is reduced and vice-versa. Capacitance may also be controlled by varying the surface area of leads 20 and 22 disposed on polymer film 18. If the surface area of leads 20 and/or 22 disposed on polymer film 18 is increased, capacitance at that particular lead will also increase. Likewise, if the surface area of leads 20 and/or 22 is reduced on polymer film 18, capacitance is reduced. As shown, package 10 is relatively inexpensive and safe to manufacture and includes features that make it relatively easy to use.

FIG. 2 is a highly enlarged isometric view of an RF device package 30 in accordance with the present invention. Package 30 is essentially the same as package 10 of FIG. 1 except for the configuration of metal leads 32 and 34 and the way leads 32 and 34 are attached to RF die 36. Therefore, preferred materials and the like of various portions of package 30 will not be discussed here when they are the same as the corresponding portions of package 10 of FIG. 1. Leads 32 and 34 are portions of a lead tape 38 also comprising a polymer film 40 on which leads 32 and 34 are formed. Polymer film 40 includes a window 42 that is disposed about die 36 which is die attached directly to heatsink 44. Leads 32 and 34 each include a plurality of fingers 46. The fingers extend to bond pads (not shown) on die 36. Fingers 46 are bonded to die 36 by ultrasonic bonding. This method of electrically coupling leads 32 and 34 to die 36 via fingers 46 is known as TAB bonding.

As with package 10 of FIG. 1, heatsink 44 is electrically coupled to a source of die 36 via the backside of die 36 and serves as a ground. Lead 32 is coupled to a base of die 36 via fingers 46 and serves as an input lead. Lead 34 is electrically coupled to a drain of die 36 via fingers 46 and serves as an output lead. Also as with package 10 of FIG. 1, the capacitance of package 30 may also be controlled by varying the thickness of polymer film 40 and the surface area of leads 32 and 34 disposed on polymer film 40.

## Claims

1. An RF device package (10,30) comprising:
a heatsink (12,44); the ivention being characterized by:
an RF die (14,36) die bonded directly to said heatsink (12,44);
an electrically insulating polymer film (18,40) disposed about said die (14,36) on said heatsink (12,44); and
input and output leads (20,22,32,34) electrically coupled to said die (14,36) and at least partially disposed on said polymer film (18,40).

2. The package (10) of claim 1 wherein the input and output leads (20,22) are wirebonded to the die (14).

3. The package (30) of claim 1 wherein the input and output leads (32,34) are TAB bonded to the die (36).

4. The package (10,30) of claim 1, 2 or 3 wherein the polymer film (18,40)comprises polyimide.

5. The package (10,30) of claim 1, 2, 3 or 4 wherein capacitance is controlled by varying the thickness of the film (18,40).

6. The package (10,30) of claim 1, 2, 3, 4 or 5 wherein capacitance is controlled by varying the surface area of the leads (20,22,32,34) disposed on the film (18,40).

7. An RF device package (10,30) comprising:
a metal heatsink (12,44); the invention being characterized by:
an RF die (14, 36) die bonded directly to said heatsink (12,44);
an electrically insulating polyimide film (18,40) disposed about said die (14,36) on said heatsink (12,44); and
metal input and output leads (20,22,32,34) electrically coupled to said die (14,36) and at least partially disposed on said polyimide film (18,40).

8. A method of fabricating an RF device package (10,30) comprising the steps of:
providing a heatsink (12,44); the invention being characterized by:
die bonding an RF die (14,36) directly to said heatsink (12,44);
applying a lead tape (16,38) comprising an electrically isolating polymer film (18,40) and input and output leads (20,22,32,34) to said heatsink (12,44) about said die (14, 36); and
electrically coupling said leads (20,22,32,34) to said die (14,36).
